# EUROPÄISCHE PATENTSCHRIFT

(11) **EP 0 998 176 B1**
(45) Veröffentlichungstag und Bekanntmachung des Hinweises auf die Patenterteilung: **10.12.2003**
(21) Anmeldenummer: 99116665.3
(22) Anmeldetag: 26.08.1999
(51) Int. Cl.: H05K 5/00, G05B 19/042, G11C 16/10

(54) **Programmierung von Steuergeräten bei geschlossenem Gehäuse**
Controllers programming in closed casing
Programmation d'unités de commande en boîtier fermé

(30) Priorität: 29.10.1998 DE 19849878
(43) Veröffentlichungstag der Anmeldung: 03.05.2000
(73) Patentinhaber: ROBERT BOSCH GMBH, 70442 Stuttgart (DE)
(72) Erfinder: Lamm, Hubert, 77876 Kappelrodeck (DE); Steuer, Peter, 76149 Karlsruhe (DE); Haderer, Guenter, 77815 Buehl (DE)

(56) Entgegenhaltungen:
- WO-A-91/07753
- DE-A- 3 704 319
- DE-U- 29 810 384
- FR-A- 2 741 953
- US-A- 5 665 653

## Beschreibung

### Stand der Technik

Die Erfindung betrifft ein elektrisches, programmierbares Steuergerät, das in einem geschlossenen Kunststoffgehäuse untergebracht ist.

Bei derartigen Steuergeräten bereitet das Umprogrammieren erhebliche Schwierigkeiten. Während der Entwicklungsphase kommt es sehr häufig vor, dass z. B. Vorserienteile immer einmal wieder umprogrammiert werden müssen.

Bisher werden Steuergeräte mit geschlossenem Kunststoffgehäuse bei der Elektronikfertigung bei der Endprüfung mit dem aktuellen Programm- oder Parametersatz programmiert und anschließend in dem Kunststoffgehäuse verschlossen. Zum Umprogrammieren ist eine zeitaufwendige Demontage des Kunststoffgehäuses nötig, um an die Programmieranschlüsse des Steuergerätes gelangen zu können.

Aus dem Gebrauchmuster DE-U-2 98 10 384 ist ebenfalls ein programmierbares Gerät der eingangs genannten Art bekannt, wobei ein programmierbares Gerät in einem Kunstoffgehäuse untergebracht ist und Programmier anschlüsse des Gerätes als Lötpads ausgebildet sind.

Es ist Aufgabe der Erfindung, ein Steuergerät der eingangs erwähnten Art so zu gestalten, dass es leicht umprogrammierbar ist.

Diese Aufgabe wird nach der Erfindung dadurch gelöst, dass Programmieranschlüsse des Steuergerätes als Lötpads ausgebildet sind, die unmittelbar hinter dünnwandigen, leicht durchstoßbaren Wandbereichen des Kunststoffgehäuses angeordnet sind.

Über die dünnen Wandbereiche des Kunststoffgehäuses ist speziell der Zugang zu den Programmieranschlüssen des Steuergerätes erleichtert, da diese Wandbereiche leicht zerstört, d. h. geöffnet, werden können, was z. B. mit spitzen Nadeln ausgeführt werden kann. Die Umprogrammierung des Steuergerätes kann mit erheblicher Kostenreduzierung vorgenommen werden.

Dabei ist nach einer Weiterbildung vorgesehen, dass die Wandbereiche auf der Außenseite des Kunststoffgehäuses mit Markierungen gekennzeichnet sind.

Ist die Ausgestaltung so, dass die Wandbereiche in als Einführungsschrägen ausgebildeten Wandabschnitten vertieft angeordnet sind, dann werden die zum Durchstoßen der Wandbereiche verwendeten Nadeln gezielt auf die dünnen Wandbereiche geführt.

Der Umprogrammiervorgang kann dadurch noch vereinfacht werden, dass die Wandbereiche mittels Kontaktnadeln an den Enden von Programmierleitungen durchstoßbar sind, wobei die Kontaktnadeln mit den als Lötpads ausgebildeten Programmieranschlüssen des Steuergerätes in elektrisch leitende Verbindung bringbar sind.

Ist die Umprogrammierung beendet, dann werden die geöffneten Wandbereiche wieder verschlossen. Dazu kann vorgesehen sein, dass die geöffneten Wandbereiche mittels Aufkleber verschließbar sind oder dass der Verschluß durch Ausgießen mit Vergußmasse vornehmbar ist. Die Einstichöffnungen können auch mittels eines Ventils verschlossen werden.

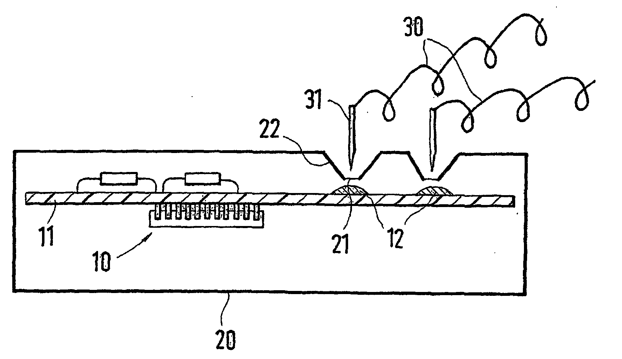

Die Erfindung wird anhand eines in der Zeichnung dargestellten Ausführungsbeispiels näher erläutert.

Das elektrische, programmierbare Steuergerät 10 ist in der Regel auf einer Leiterplatte 11 angeordnet und mit Programmieranschlüssen 12 versehen. Diese Programmanschlüsse 12 sind als Lötpads ausgebildet und unmittelbar in kleinem Abstand zu sehr dünnen Wandbereichen 21 des allseitig geschlossenen Kunststoffgehäuses 20 angeordnet. Im einfachsten Fall können diese dünnen Wandbereiche 21 auf der Außenseite des Kunststoffgehäuses 20 mit Markierungen gekennzeichnet sein. Sind die an die dünnen Wandbereiche 21 anschließenden Wandabschnitte als Einführungsschrägen 22 zu den vertieft liegenden Wandbereichen 21 ausgebildet, dann werden Kontaktnadeln 31 der Programmierleitungen 30, die zum Durchstoßen der Wandbereiche 21 verwendet werden, eindeutig auf die Wandbereiche 21 geführt.

Nach dem Durchstoßen der Wandbereiche 21 kommen die Kontaktnadeln 21 der Programmierleitungen 30 mit den als Lötpads ausgebildeten Programmieranschlüssen 12 des Steuergerätes 10 in elektrische Verbindung, so dass eine Umprogrammierung des Steuergeräts 10 vorgenommen werden kann.

Ist die Umprogrammierung beendet, dann lassen sich die Einstichstellen in den Wandbereichen 21 wieder dicht verschließen. Dazu können Aufkleber verwendet werden. Die Einstichstellen können aber auch mittels Vergußmasse verschlossen werden, die die Vertiefungen zu den Wandbereichen 21 ausfüllt. Der dichte Verschluß kann auch über einsetzbare Ventile vorgenommen werden.

Bei dieser Ausgestaltung des Kunststoffgehäuses wird eine Beschädigung außerhalb der Wandbereiche 21 vermieden. Es wird lediglich ein leichter Zugang zu den Programmieranschlüssen geschaffen, der nur beim Umprogrammieren vorgenommen wird. Die mit den Kontaktnadeln 31 der Programmierleitungen 30 erzeugten Einstichstellen reichen aus und sind wieder leicht zu schließen.

## Patentansprüche

1. Elektrisches, programmierbares Steuergerät, das in einem geschlossenen Kunststoffgehäuse untergebracht ist,
**dadurch gekennzeichnet,**
**dass** Programmieranschlüsse (12) des Steuergerätes (10) als Lötpads ausgebildet sind, die unmittelbar hinter dünnwandigen, durchstoßbaren Wandbereichen (21) des Kunststoffgehäuses (20) angeordnet sind, um den Zugang zu den Programmier anschlüssen des Steuergerätes zu erleichtern.

2. Steuergerät nach Anspruch 1,
**dadurch gekennzeichnet,**
**dass** die Wandbereiche (21) auf der Außenseite des Kunststoffgehäuses (20) mit Markierungen gekennzeichnet sind.

3. Steuergerät nach Anspruch 1 oder 2,
**dadurch gekennzeichnet,**
**dass** die Wandbereiche (21) in als Einführungsschrägen (22) ausgebildeten Wandabschnitten vertieft angeordnet sind.

4. Steuergerät nach einem der Ansprüche 1 bis 3,
**dadurch gekennzeichnet,**
**dass** die Wandbereiche (21) mittels Kontaktnadeln (31) an den Enden von Programmierleitungen (30) durchstoßbar sind, wobei die Kontaktnadeln (31) mit den als Lötpads ausgebildeten Programmieranschlüssen (12) des Steuergerätes (10) in elektrisch leitende Verbindung bringbar sind.

5. Steuergerät nach einem der Ansprüche 1 bis 4,
**dadurch gekennzeichnet,**
**dass** nach der Umprogrammierung die geöffneten Wandbereiche (21) wieder verschließbar sind.

6. Steuergerät nach Anspruch 5,
**dadurch gekennzeichnet,**
**dass** die geöffneten Wandbereiche (21) mittels Aufkleber verschließbar sind.

7. Steuergerät nach Anspruch 5,
**dadurch gekennzeichnet,**
**dass** der Verschluß durch Ausgießen mit Vergußmasse vornehmbar ist.

8. Steuergerät nach Anspruch 5,
**dadurch gekennzeichnet,**
**dass** der Verschluß mit einem Ventil ausführbar ist.

## Claims

1. Electrical, programmable controller, which is accommodated in a closed plastic casing, **characterized in that** programming terminals (12) of the controller (10) are formed as solder pads which are arranged directly behind thin-walled penetrable wall regions (21) of the plastic casing (20), in order to facilitate access to the programming terminals of the controller.

2. Controller according to Claim 1, **characterized in that** the wall regions (21) on the outer side of the plastic casing (20) are provided with markings.

3. Controller according to Claim 1 or 2, **characterized in that** the wall regions (21) are arranged recessed in wall portions formed as tapered lead-ins (22).

4. Controller according to one of Claims 1 to 3, **characterized in that** the wall regions (21) are penetrable by means of contact needles (31) at the ends of programming lines (30), the contact needles (31) being able to be brought into an electrically conducting connection with the programming terminals (12) of the controller (10) formed as solder pads.

5. Controller according to one of Claims 1 to 4, **characterized in that**, after the reprogramming, the opened wall regions (21) can be closed again.

6. Controller according to Claim 5, **characterized in that** the opened wall regions (21) can be closed by means of stickers.

7. Controller according to Claim 5, **characterized in that** the closure can be performed by filling.with sealing compound.

8. Controller according to Claim 5, **characterized in that** the closure can be performed with a valve.

## Revendications

1. Appareil de commande programmable électrique logé dans un boîtier fermé en matière plastique,
**caractérisé en ce que**
les raccordements de programmation (12) de l'appareil de commande (10) ont la forme de pastilles à souder, disposées directement derrière des zones des parois (21) fines et perforables du boîtier en matière plastique (20) pour faciliter l'accès aux raccordements de programmation de l'appareil de commande.

2. Appareil de commande selon la revendication 1,
**caractérisé en ce que**
les zones de paroi (21) sont désignées par des marques à l'extérieur du boîtier en matière plastique (20).

3. Appareil de commande selon la revendication 1 ou 2,
**caractérisé en ce que**
les zones de paroi (21) sont disposées en retrait, en tant que sections de paroi formées en biseaux d'introduction (22).

4. Appareil de commande selon l'une quelconque des revendications 1 à 3,
**caractérisé en ce que**
les zones de paroi (21) sont perforables au moyen d'aiguilles de contact (31) aux extrémités des lignes de programmation (30), les aiguilles de contact (31) pouvant être reliées de manière conductrice aux raccordements de programmation (12) en forme de pastilles à souder de l'appareil de commande (10).

5. Appareil de commande selon l'une quelconque des revendications 1 à 4,
**caractérisé en ce que**
après la reprogrammation, les zones de paroi (21) ouvertes peuvent de nouveau être fermées.

6. Appareil de commande selon la revendication 5,
**caractérisé en ce que**
les zones de paroi (21) ouvertes peuvent être fermées au moyen d'autocollants.

7. Appareil de commande selon la revendication 5,
**caractérisé en ce que**
la fermeture peut s'effectuer par scellement de masse de remplissage.

8. Appareil de commande selon la revendication 5,
**caractérisé en ce que**
la fermeture peut s'effectuer par une soupape.
